# EUROPEAN PATENT APPLICATION

(11) **EP 3 798 806 A1**
(43) Date of publication of application: **31.03.2021**
(21) Application number: 20197586.9
(22) Date of filing: 22.09.2020
(51) Int. Cl.: G06F 3/042, G06F 3/01

(54) **CONTROL INPUT DEVICE**

(30) Priority: 26.09.2019 GB 201913927
(71) Applicant: Kano Computing Limited, London Middlesex EC2M 2PA (GB)
(72) Inventor: Supper, Ben, London, Middlesex EC2M 2PA (GB); Wood, Ted, London, Middlesex EC2M 2PA (GB); Klein, Alex, London, Middlesex EC2M 2PA (GB); Dervish, Kemal, London, Middlesex EC2M 2PA (GB); Schneiderman, Elliot, London, Middlesex EC2M 2PA (GB); Griffith, Peter, London, Middlesex EC2M 2PA (GB); Subrahmanya, Chaithrika, London, Middlesex EC2M 2PA (GB); Sathe, Vaish, London, Middlesex EC2M 2PA (GB); Hicks, James, London, Middlesex EC2M 2PA (GB); Gabor, Gabriel, London, Middlesex EC2M 2PA (GB); Love, Dan, London, Middlesex EC2M 2PA (GB)
(74) Representative: Wilson Gunn

(57) **Abstract**

A control input device for a linked system comprising: a plurality of proximity sensors, each proximity sensor operable to determine the relative proximity of any objects within a detection zone associated with the proximity sensor and output a proximity signal in response; a core unit operable to receive proximity signals from each proximity sensor and output a directional signal in response thereto; a communication unit operable to communicate the directional signal to the linked system; and one or more illumination units associated with each proximity sensor, wherein the one or more illumination units associated with each proximity sensor are operated in response to the proximity signal output by the associated proximity sensor.

## Description

### Technical Field of the Invention

The present invention relates to a control input device. In particular, the present invention relates to a control input device for a linked computer or other system.

### Background to the Invention

It is common to enable users to interact with linked systems such as computers or the like by way of a control input device. The control input device may be adapted to enable a user to make control inputs in a simple and/or intuitive manner. The inputs can then be translated into control signals to control the operation of a linked system.

In particular, control input devices can be used to readily and intuitively allow uses to make directional control inputs to a linked system. An example of such a control input device is a joystick, joypad or computer mouse. Joysticks comprise and elongate grip projecting from a base. The grip is provided with a base end attached within a multidirectional socket within the base such that the tilt of the grip relative to the base may be adjusted. By detecting motion of the base end within the socket, the relative tilt of the grip to the base can be determined. The relative tilt may then be translated to a directional control input.

The mechanical connection between the grip and base of a joystick or equivalent components of other such devices provides for ready intuitive feedback to a user. nevertheless, the mechanical connection is also a potential point of failure for the device.

Other control input devices such as touch screens and touch pads do not require mechanical joints to detect user input. Nevertheless, such devices struggle to provide an equivalent level of intuitive feedback to a user on control inputs.

It is therefore an object of the present invention to provide an alternative control input device.

### Summary of the Invention

According to a first aspect of the present invention there is provided a control input device for a linked system comprising: a plurality of proximity sensors, each proximity sensor operable to determine the relative proximity of any objects within a detection zone associated with the proximity sensor and output a proximity signal in response; a core unit operable to receive proximity signals from each proximity sensor and output a directional signal in response thereto; a communication unit operable to communicate the directional signal to the linked system; and one or more illumination units associated with each proximity sensor, wherein the one or more illumination units associated with each proximity sensor are operated in response to the proximity signal output by the associated proximity sensor.

This therefore provides a control input device that can provide a directional signal output and intuitive feedback to a user without requiring mechanical attachment and relative motion between components of the control input device.

The device may comprise two, three, for or more proximity sensors. In a preferred embodiment, the device may comprise four proximity sensors.

The proximity sensors may each be provided on a common sensor platform. The proximity sensors may be evenly spaced around a ring defined on the sensor platform. The centre of said ring may be coincident with the centre of the platform. The sensor platform may comprise a printed circuit board (PCB).

The proximity sensors may be active infrared proximity sensors. Such sensors comprise an emitting element operable to emit an infrared beam and a receiving element operable to receive reflections of the infrared beam. The emitting element may be an LED. The receiving element may be a photodiode.

Such sensors may further comprise a processing unit operable to determine the proximity of any objects generating reflections of the infrared beam on the basis of the time elapsed between emission and detection. The processing unit may be operable to output the proximity signal in response to the determined time elapsed between emission and detection.

Each proximity sensor may have a detection zone. The lateral limits of the detection zone may be defined by the edges of the emitted beam. The maximum range of the detection zone may be defined by disregarding barn reflections received outside a preset time window.

In some embodiments, each proximity sensor may be operable in parallel. In other embodiments, each proximity sensor may be operable in consecutive dedicated operation window. This has the advantage that the potential for reflected beams to be detected by other proximity sensors is reduced.

The output of the one or more illumination units associated with each proximity sensor may be varied in response to the proximity signal output by the associated proximity sensor. In this context, the output variation may include variations in intensity, colour or period of illumination. For example, the intensity of light output by the illumination units may be increased in response to a proximity signal indicating greater proximity of a detected object. This can help provide a user with feed back as to the nature of the directional signal.

Each illumination unit associated with a proximity sensor may undergo the same variation. In alternative embodiments, different variations may be undergone by different illumination units associated with a proximity sensor. In one embodiment output variation may be greatest for illumination units closest to the proximity sensor. This can help provide a user with feedback as to the location of each proximity sensor.

The illumination units may be LEDs. The LEDs may be monochrome LEDs or compound white light or coloured light LEDs as desired or as required.

The illumination units may be provided on the sensor platform. The illumination units may be evenly spaced around a ring defined on the sensor platform. The centre of said ring may be coincident with the centre of the platform. The illumination units may be provided with a light diffuser. In some embodiments, the light diffuser may be a ring diffuser corresponding to the ring defining the illumination unit spacing. By diffusing light around the ring diffuser more effective visual feedback may be provided to a user.

The core unit may be operable to process the received core signals to calculate the directional signal. The calculation may include the step of performing a weighted sum of the individual proximity signals. Alternatively, the core unit may be operable to determine the proximity signal by collating the most recent proximity signals from, each proximity sensor. The collated proximity signals may then be proceed by the linked system

The system may be a computer system including but not limited to a desktop computer, laptop computer, tablet computer, smartphone, games console, media player or the like. In other implementations, the system may be any other suitable system including but not limited to environmental control systems such as heating, ventilation, air conditioning or lighting systems.

The communication unit may be operable to communicate data with the system by any suitable wired or wireless communication link. In a preferred embodiment, the communication link is by way of a wireless protocol such as WiFi, Bluetooth, Bluetooth low energy or the like.

The device may comprise a power source. The power source may comprise one or more internal batteries. The batteries may be rechargeable or replaceable as desired or as required. The power source may comprise a power socket suitable for receiving an external power connection. The external power connection may be used to directly power the device and/or to recharge any internal power source.

The device may comprise a decorative token. The decorative token may function as a light diffuser. The decorative token may be provided with one or more token illumination units operable to illuminate the decorative token. The output of the token illumination units may be varied in response to the directional signal.

The device may be provided with a protective housing. The protective housing may comprise one or more infrared apertures. The apertures may be aligned with the proximity sensors. This allows beams emitted by the proximity sensors to leave the protective housing and for beam reflections from objects to return to the proximity sensors.

According to a second aspect of the present invention there is provided a method of operating a control input device of the type comprising a plurality of proximity sensors, each proximity sensor operable to determine the relative proximity of any objects within a detection zone associated with the proximity sensor and output a proximity signal in response, and one or more illumination units associated with each proximity sensor, the method comprising the steps of: receiving proximity signals from each proximity sensor and outputting a directional signal in response thereto; communicating the directional signal to the linked system; and operating said illumination units associated with each proximity sensor in response to the proximity signal output by the associated proximity sensor.

The method of the second aspect of the present invention may include any or all features of the device of the first aspect of the present invention as desired or as appropriate.

According to a third aspect of the present invention, there is provided a method of controlling a system comprising the steps of providing a control input device according to the present invention; and moving an object within a detection zone of the control input device so as to generate a directional signal; and varying operation of the stem in response to the generated directional signal.

The method of the third aspect of the present invention may include any or all features of the first and second aspects of the present invention as desired or as appropriate.

### Detailed Description of the Invention

In order that the invention may be more clearly understood one or more embodiments thereof will now be described, by way of example only, with reference to the accompanying drawings, of which:
- Figure 1: is a schematic block diagram of a control input device according to the present invention;
- Figure 2: shows (a) top (b) perspective and (c) exploded views of a first embodiment of a control input device according to the present invention; and
- Figure 3: shows (a) top (b) perspective and (c) exploded views of a second embodiment of a control input device according to the present invention.

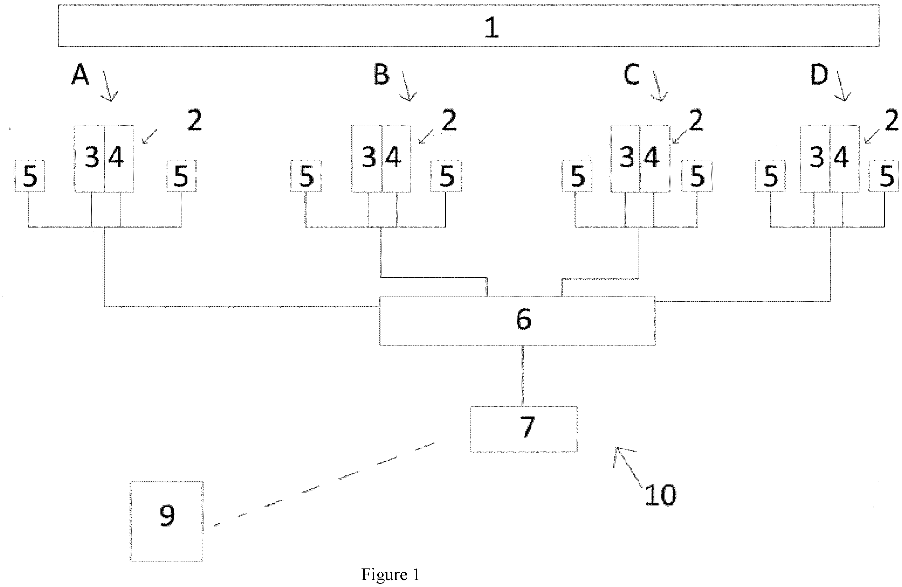

Turning now to figure 1, a control input device 10 comprises a plurality of proximity sensors 2, each operable to detect the relative proximity of an object 1. The object 1, may be a user's had or the like. The proximity sensors 2 are each provided with associated illumination units 5, typically LEDs so as to form a sensor and feedback assembly. In the illustrated example, there are four such assemblies (A, B, C, D) and two illumination units 5 associated with each assembly A, B, C, D. The skilled man will nevertheless appreciate that different numbers of assemblies A, B, C, D and different numbers of illuminations units 5 per assembly may be provided.

Each proximity sensor comprises an infrared emitter 3, typically an LED and an infrared receiver 4, typically a photodiode. The emitter 3 is operable to emit an infrared beam and the receiver 4 is operable to detect reflections of the infrared beam from the object 1. By determining the time interval between emission and receipt, the proximity sensor 2 can determine the proximity of the object 1. The proximity sensor 2 can therefore output a proximity signal in response to the detected proximity of the object 1.

A core unit 6 is operable to receive the proximity signal output by each proximity sensor 2. By performing a weighted sum on the proximity signals, the core unit can calculate the relative proximity of the object 1 to each proximity sensor 2. This relative proximity can be converted to a corresponding directional signal and communicated to a linked system 9, such as a computer via a communication unit 7. Typically, the communication unit 7 is a wireless communication unit operable according to a standard protocol such as WiFi, Bluetooth, Bluetooth low energy or the like. The directional signal can thus provide a control input for the system 9. For example, the directional signal may be used to control the motion of a character or sprite in a computer game or the position of a cursor on a computer display.

In alternative embodiments, the core unit 6 may simply collate output proximity signals and processing may be carried out after transmission to the linked system 9.

To avoid discrepancies due to reflected beams being detected by adjacent proximity sensors 2, each sensor 2 may be operated in sequential sensing windows. For example, each assembly A, B, C, D may be actively operated for sequential 11ms periods. This would allow a full proximity sensing for each of the four assemblies to be completed in 44ms.

The illumination units 5 associated with each proximity sensor 2 are operated in response to the output proximity signal. In particular, the intensity or colour of the light output by the illumination units 5 associated with a proximity sensor are varied in response to the proximity of the detected object 1 to the proximity sensor 2. In one example, the illumination units may be operable to emit more intense light as the relative proximity of the object 1 to the proximity sensor increases.

The above operation of the illumination units thus provides a user with ready visual feedback as to the operation of the control device 10. Beneficially, this feedback does not require mechanical motion between components of the device 10. Additionally, this feedback does not necessarily obscure an area of a display screen of the linked system.

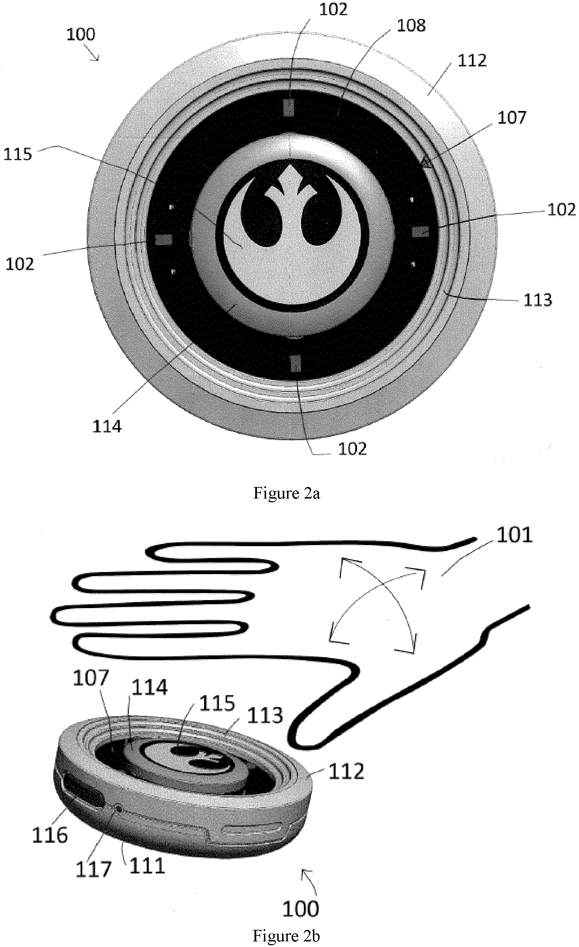

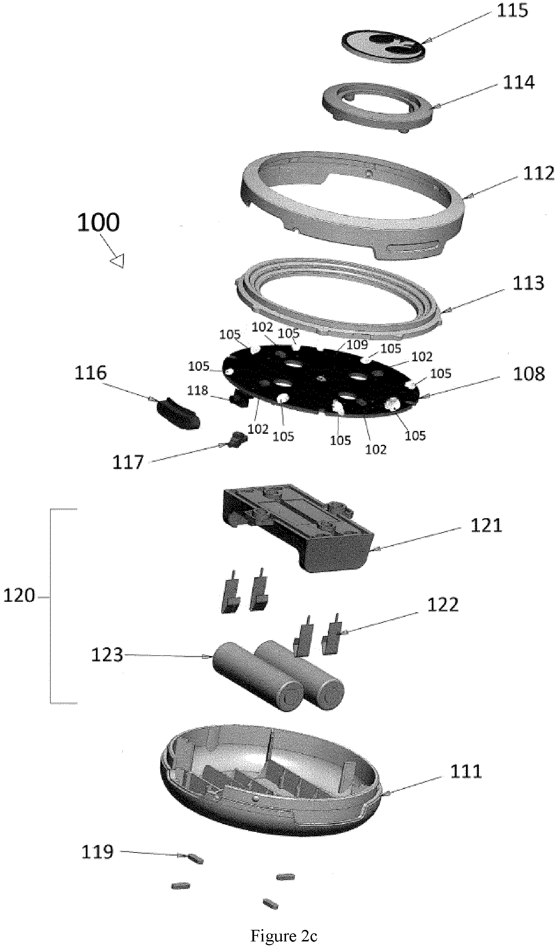

Turning now to figure 2, one embodiment of a control device 100 according to the present invention is shown. In this embodiment, the control device 100 is provided within a housing 110. Within the housing 110 is a sensor platform 108, typically a PCB, upon which four proximity sensors 102 are mounted. The proximity sensors 102 are evenly spaced along a ring concentric with the sensing platform 108. Typically, a core unit (not shown) and communication unit (not shown) would be formed on or mounted to the sensor platform 108.

The housing 110 comprises a base 111 for receiving the sensor platform 108 and a top 112, which engages with the base 111. A ring diffuser 113 is retained between the top 112 and the sensor platform 108. The ring diffuser 113 fits over illumination units 105 associated with each proximity sensor 102. Accordingly, operation of and variation of operation of illumination units 105 can be readily perceived by a user.

A further illumination unit 109 is provided at the centre of the sensor platform 108. The further illumination unit 109 is covered by a decorative token 115, which is retained in position relative to the sensor platform 108 by a cap 114. The decorative token 115 is typically at least partially transparent or translucent so as to display a decorative element when illumination unit 109 is operative. In some embodiments, illumination unit 109 is operative at all times that device 100 is switched on.

In this embodiment, between the cap 114 and the ring diffuser 113 is defined an aperture 107. This aperture 107 allows for the emission of beams by proximity sensors 102 and the detection of reflected beams by the proximity sensors 102. In some embodiments, the aperture 107 may be covered or filled by a transparent material to provide further protection for the proximity sensors 102. The relative proximity of an object such as hand 101 can therefore be determined and a corresponding direction signal generated. Motion of the hand 110 as indicated by the arrows in figure 2b can vary the relative proximity detected by each proximity sensor 102 and hence the generated directional signal. This varied directional signal can thus provide a control input for a linked system (not shown).

The embodiment shown further illustrates a power button 116 which is retained between base 111 and top 112. The power button may be actuated by a user to operate power switch 117 mounted on sensor platform 108. This can switch device 100 on or off. A light pipe 117 is also retained between base 111 and top 112. This can direct light from any of the illumination units 105, 109 or another dedicated illumination unit to the exterior of housing 110. This can provide a visual confirmation of the power status of the device 100.

The base 111 can additionally retain some gripping elements 119. The gripping elements 119 are typically formed or a resilient material and help retain the device 100 in position when resting on a surface.

In the embodiment shown, the device 100 further comprises a power supply 120 comprising a battery holder 121 retained between base 111 and sensor platform 108, battery contacts 122 fitted to battery holder 121 and batteries 123. The batteries 123 may be removable and/or rechargeable.

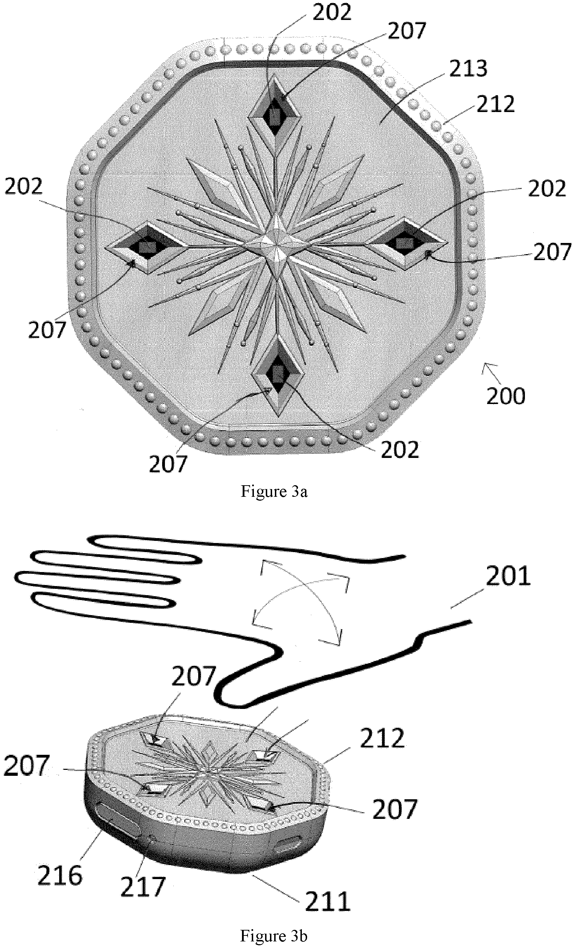

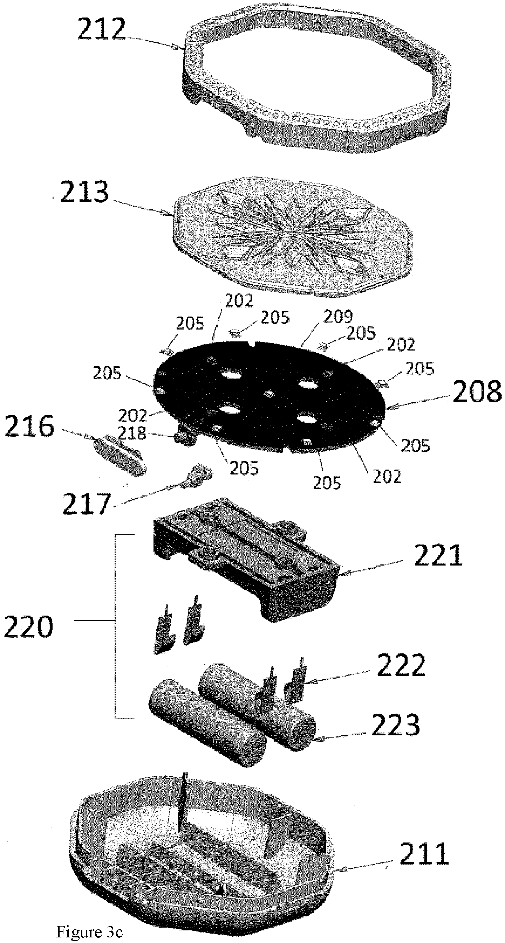

Turning now to figure 3, another embodiment of a control device 200 according to the present invention is shown. In this embodiment, the control device 200 is provided within a housing 210. Within the housing 210 is a sensor platform 108, typically a PCB, upon which four proximity sensors 202 are mounted. The proximity sensors 202 are evenly spaced along a ring concentric with the sensing platform 208. Typically, a core unit (not shown) and communication unit (not shown) would be formed on or mounted to the sensor platform 208. A further illumination unit 209 is provided at the centre of the sensor platform 208.

The housing 210 comprises a base 211 for receiving the sensor platform 208 and a top 212, which engages with the base 211. A cover 213 is retained between the top 212 and the sensor platform 208. The cover 213 fits over illumination units 205 associated with each proximity sensor 202. The cover 213 is typically at least partially transparent or translucent around its edges. Accordingly, operation of and variation of operation of illumination units 205 can be readily perceived by a user.

The cover 213 is typically at least partially transparent or translucent in a central portion so as to display a decorative element when illumination unit 209 is operative. In some embodiments, illumination unit 109 is operative at all times that device 100 is switched on.

In this embodiment, between the cover 213 is provided with apertures 207. The apertures 207 allows for the emission of beams by proximity sensors 202 and the detection of reflected beams by the proximity sensors 202. In some embodiments, the apertures 207 may be covered or filled by a transparent material to provide further protection for the proximity sensors 102. The relative proximity of an object such as hand 201 can therefore be determined and a corresponding direction signal generated. Motion of the hand 201 as indicated by the arrows in figure 3b can vary the relative proximity detected by each proximity sensor 202 and hence the generated directional signal. This varied directional signal can thus provide a control input for a linked system (not shown).

The embodiment shown further illustrates a power button 216 which is retained between base 211 and top 212. The power button may be actuated by a user to operate power switch 217 mounted on sensor platform 208. This can switch device 200 on or off. A light pipe 217 is also retained between base 211 and top 212. This can direct light from any of the illumination units 205, 209 or another dedicated illumination unit to the exterior of housing 210. This can provide a visual confirmation of the power status of the device 200.

In the embodiment shown, the device 200 further comprises a power supply 220 comprising a battery holder 221 retained between base 211 and sensor platform 208, battery contacts 222 fitted to battery holder 221 and batteries 223. The batteries 223 may be removable and/or rechargeable.

The one or more embodiments are described above by way of example only. Many variations are possible without departing from the scope of protection afforded by the appended claims.

## Claims

1. A control input device for a linked system comprising: a plurality of proximity sensors provided evenly spaced around a ring defined on a common sensor platform, each proximity sensor operable to determine the relative proximity of any objects within a detection zone associated with the proximity sensor and output a proximity signal in response; a core unit operable to receive proximity signals from each proximity sensor and output a directional signal in response thereto; a communication unit operable to communicate the directional signal to the linked system; and one or more illumination units associated with each proximity sensor, wherein the one or more illumination units associated with each proximity sensor are operated in response to the proximity signal output by the associated proximity sensor to indicate directionality of a motion relative to the plurality of sensors.

2. A control input device as claimed in any preceding claim wherein the proximity sensors are active infrared proximity sensors.

3. A control input device as claimed in any preceding claim wherein each proximity sensor has a detection zone.

4. A control input device as claimed in any preceding claim wherein each proximity sensor is operable in consecutive dedicated operation windows.

5. A control input device as claimed in any preceding claim wherein the output of the one or more illumination units associated with each proximity sensor is varied in response to the proximity signal output by the associated proximity sensor.

6. A control input device as claimed in claim 5 wherein output variation includes variations in intensity, colour or period of illumination.

7. A control input device as claimed in claim 5 or claim 6 wherein each illumination unit associated with a proximity sensor undergoes the same variation.

8. A control input device as claimed in claim 5 or claim 6 wherein different variations are undergone by different illumination units associated with a proximity sensor.

9. A control input device as claimed in any preceding claim wherein the illumination units are provided on the sensor platform.

10. A control input device as claimed in claim 9 wherein the illumination units are evenly spaced around a ring defined on the sensor platform.

11. A control input device as claimed in any preceding claim wherein the illumination units are provided with a light diffuser.

12. A control input device as claimed in any preceding claim wherein the core unit is operable to process the received core signals to calculate the directional signal.

13. A control input device as claimed in claim 12 wherein the calculation includes performing a weighted sum of the individual proximity signals.

14. A control input device as claimed in any preceding claim wherein the core unit is operable to determine the proximity signal by collating the most recent proximity signals from, each proximity sensor.

15. A control input device as claimed in claim 14 wherein the collated proximity signals are then processed by the linked system.

16. A control input device as claimed in any preceding claim wherein the device comprises a decorative token operable as a light diffuser.

17. A control input device as claimed in claim 16 wherein the decorative token is provided with one or more token illumination units operable to illuminate the decorative token.

18. A control input device as claimed in claim 17 wherein the output of the token illumination units is varied in response to the directional signal.

19. A method of operating a control input device of the type comprising a plurality of proximity sensors, each proximity sensor operable to determine the relative proximity of any objects within a detection zone associated with the proximity sensor and output a proximity signal in response, and one or more illumination units associated with each proximity sensor, the method comprising the steps of: receiving proximity signals from each proximity sensor and outputting a directional signal in response thereto; communicating the directional signal to the linked system; and operating said illumination units associated with each proximity sensor in response to the proximity signal output by the associated proximity sensor.

20. A method of controlling a system comprising the steps of providing a control input device according to any one of claims 1 to 18 or operable according to the method of claim 19; and moving an object within a detection zone of the control input device so as to generate a directional signal; and varying operation of the stem in response to the generated directional signal.
